# EUROPEAN PATENT APPLICATION

(11) **EP 4 761 521 A1**
(43) Date of publication of application: **17.06.2026**
(21) Application number: 25170862.4
(22) Date of filing: 16.04.2025
(51) Int. Cl.: H10F 19/90, H10F 77/20, H10F 77/00

(54) **BACK-CONTACT SOLAR CELL MODULE AND MANUFACTURING METHOD THEREOF**

(30) Priority: 12.12.2024 CN 202411833685
(71) Applicant: JINKO SOLAR CO., LTD, ShangRao, Jiangxi 334100 (CN); Jinko Solar (Haining) Co., Ltd., Haining City, Zhejiang 314415 (CN)
(72) Inventor: TAO, Wusong, Shangrao (CN); WANG, Luchuang, Shangrao (CN); HAN, Xiangchao, Shangrao (CN); SONG, Yongqiao, Shangrao (CN)
(74) Representative: Botti & Ferrari S.p.A.

(57) **Abstract**

Provided are a back-contact solar cell module and a manufacturing method thereof. The back-contact solar cell module includes a solar cell, a busbar, a plurality of first-polarity solder strips, a plurality of second-polarity solder strips, and an insulating film. The busbar, the plurality of first-polarity solder strips, the plurality of second-polarity solder strips, and the insulating film are all arranged on a back surface of the solar cell. The first-polarity solder strips and the second-polarity solder strips are alternately arranged on the back surface of the solar cell, the first-polarity solder strips are electrically connected to the busbar, and the insulating film can isolate the busbar from the solar cell. Along a thickness direction of the solar cell, the first-polarity solder strips and the second-polarity solder strips are respectively arranged on two sides of the insulating film.

## Description

### TECHNICAL FIELD

The present disclosure relates to the technical field of solar cells, and in particular, to a back-contact solar cell module and a manufacturing method thereof.

### BACKGROUND

Currently, in conventional modules, the busbars are placed at head, tail, and middle positions of the modules, which may occupy the space of the modules, resulting in lower area utilization and power output of the modules.

### SUMMARY

Embodiments of the present disclosure provide a back-contact solar cell module and a manufacturing method thereof, intended to arrange a busbar on a back surface of the back-contact solar cell module to improve area utilization of the back-contact solar cell module and also improve current collection efficiency.

Embodiments of the present disclosure provide a back-contact solar cell module, including: a solar cell; a busbar arranged on a back surface of the solar cell; a plurality of first-polarity solder strips and a plurality of second-polarity solder strips, the first-polarity solder strips and the second-polarity solder strips being alternately arranged on the back surface of the solar cell, and the first-polarity solder strips being electrically connected to the busbar; and an insulating film capable of insulating the busbar from the solar cell, along a thickness direction of the solar cell, the first-polarity solder strips and the second-polarity solder strips being respectively arranged on two sides of the insulating film.

In one or more embodiments, along the thickness direction of the solar cell, the first-polarity solder strips are arranged above the busbar, and the second-polarity solder strips are arranged between the insulating film and the solar cell.

In one or more embodiments, along the thickness direction of the solar cell, the first-polarity solder strips are arranged between the busbar and the insulating film, and the second-polarity solder strips are arranged between the insulating film and the solar cell.

In one or more embodiments, along the thickness direction of the solar cell, the insulating film is arranged between the busbar and the solar cell.

In one or more embodiments, the insulating film is provided with second connecting holes, and the busbar is capable of being electrically connected to corresponding gridlines of the solar cell through the second connecting holes; or the insulating film is provided with second connecting holes, and the first-polarity solder strips are capable of being electrically connected to corresponding gridlines of the solar cell through the second connecting holes.

In one or more embodiments, the busbar is arranged at a middle position of the back surface of the solar cell, a width of the insulating film is greater than a width of the busbar, and a thickness of the busbar ranges from 0.1 mm to 0.2 mm.

In one or more embodiments, the back surface of the solar cell is provided with a plurality of pads, along an extension direction of the first-polarity solder strips, the insulating film is located between two adjacent pads, and a spacing between the two adjacent pads ranges from 8 mm to 20 mm.

Embodiments of the present disclosure further provide a manufacturing method of a back-contact solar cell module, for manufacturing the back-contact solar cell module described above, and the manufacturing method includes: arranging second-polarity solder strips over a back surface of a solar cell, and soldering the second-polarity solder strips to second-polarity gridlines of the solar cell; arranging an insulating film on the back surface of the solar cell; and arranging a busbar and first-polarity solder strips over the back surface of the solar cell, and soldering the first-polarity solder strips to first-polarity gridlines of the solar cell.

In one or more embodiments, prior to the arranging a busbar and first-polarity solder strips over the back surface of the solar cell, the manufacturing method further includes: first soldering and fixing the first-polarity solder strip and the busbar.

In one or more embodiments, the arranging a busbar and first-polarity solder strips over the back surface of the solar cell, the manufacturing method includes: arranging the first-polarity solder strips above the busbar; or arranging the first-polarity solder strips between the busbar and the insulating film.

In the embodiments of the present disclosure, by arranging the busbar over the back surface of the solar cell, a space between solar cells is saved, a space for placing busbars at edges and middle of the back-contact solar cell module is reduced. In a case where a size of the back-contact solar cell module is unchanged, more solar cells or larger-sized solar cells may be placed, which helps improve area utilization of the back-contact solar cell module, thereby improving power of the back-contact solar cell module.

Further, by arranging the busbar over the back surface of the solar cell, a length of connection between the first-polarity solder strips and the busbar is also shortened, improving a current collection effect of the first-polarity solder strips. By arranging the busbar over the back surface of the solar cell and by connecting the first-polarity solder strips to the busbar, the busbar can be fixed, and there is no need to fix the busbar again.

In addition, by distributing the first-polarity solder strips and the second-polarity solder strips on two sides of the insulating film, the second-polarity solder strips are arranged on the side of the insulating film away from the busbar, so as to isolate the busbar from the second-polarity solder strips, and prevent a short circuit caused by contact between the busbar and the second-polarity solder strips. Moreover, by distributing the first-polarity solder strip and the second-polarity solder strip on the two sides of the insulating film, the insulating film can be fixed.

It should be understood that the general description above and the detailed description in the following are merely exemplary and illustrative, and cannot limit the present disclosure.

### BRIEF DESCRIPTION OF DRAWINGS

FIG. 1 is a schematic top view of a back-contact solar cell according to one or more embodiments of the present disclosure;
FIG. 2 is a cross-sectional view of a back-contact solar cell along a cross section of a busbar according to one or more embodiments of the present disclosure;
FIG. 3 is a cross-sectional view of a back-contact solar cell along a cross section of a busbar according to one or more embodiments of the present disclosure;
FIG. 4 is a schematic diagram of a cross section of an insulating film according to one or more embodiments of the present disclosure;
FIG. 5 is a schematic diagram of an insulating film wrapping a busbar according to one or more embodiments of the present disclosure;
FIG. 6 is a schematic diagram of the insulating film wrapping first-polarity solder strips and a busbar according to one or more embodiments of the present disclosure;
FIG. 7 is a cross-sectional view of a back-contact solar cell along a cross section of a busbar according to one or more embodiments of the present disclosure;
FIG. 8 is a cross-sectional view of a back-contact solar cell along a cross section of a busbar according to one or more embodiments of the present disclosure;
FIG. 9 is a cross-sectional view of a non-back-contact solar cell along a cross section of a busbar according to one or more embodiments of the present disclosure;
FIG. 10 is a manufacturing flowchart of a back-contact solar cell according to one or more embodiments of the present disclosure;
FIG. 11 is a manufacturing flowchart of a back-contact solar cell according to one or more embodiments of the present disclosure;
FIG. 12 is a manufacturing flowchart of a back-contact solar cell according to one or more embodiments of the present disclosure; and
FIG. 13 is a manufacturing flowchart of a back-contact solar cell according to one or more embodiments of the present disclosure.

Reference signs: 1-back-contact solar cell module; 11-solar cell; 11a-back surface; 111-pad; 12-busbar; 13-first-polarity solder strip; 14-second-polarity solder strip; 15-insulating film; 151-first connecting hole; 152-second connecting hole.

The accompanying drawings herein, which are incorporated in and constitute part of this specification, illustrate embodiments consistent with the present disclosure, and together with the specification, serve to explain principles of the present disclosure.

### DESCRIPTION OF EMBODIMENTS

In order to better understand the technical solutions of the present disclosure, the embodiments of the present disclosure are described in detail below with reference to the accompanying drawings.

It should be clear that the described embodiments are only some of rather than all of the embodiments of the present disclosure.

The terms used in the embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified in the context.

It should be understood that the term "and/or" used herein describes an association relationship between associated objects and represents that three relationships may exist. For example, A and/or B may represent the following three cases: only A exists, both A and B exist, and only B exists. In addition, the character "/" herein generally indicates an "or" relationship between the associated objects.

It should be noted that directional terms such as "up", "down", "left", and "right" described in the embodiments of the present disclosure are described from the perspectives shown in the accompanying drawings and should not be construed as limitations on the embodiments of the present disclosure. In addition, in the context, it should be further understood that when an element is referred to as being connected "above" or "below" another element, the element can be directly connected "above" or "below" the another element or may be indirectly connected "above" or "below" the another element through an intermediate element.

In a conventional solar cell module, busbars are located between adjacent solar cells. In this way, the busbars occupy a large area of the module, and the internal busbars can be seen through a front surface glass or transparent packaging material of the solar cell module. The busbars directly exposed to the outside exposes an electrical structure design inside the solar cell module. During lamination process, if there are issues such as curling and offset of the busbars, for a double-glass module, irregular application of potting glue or sealant can result in an unattractive appearance at a junction box on a front surface of the module after curing, directly affecting aesthetics of the module.

To this end, embodiments of the present disclosure provides a back-contact solar cell module, to solve the above technical problems.

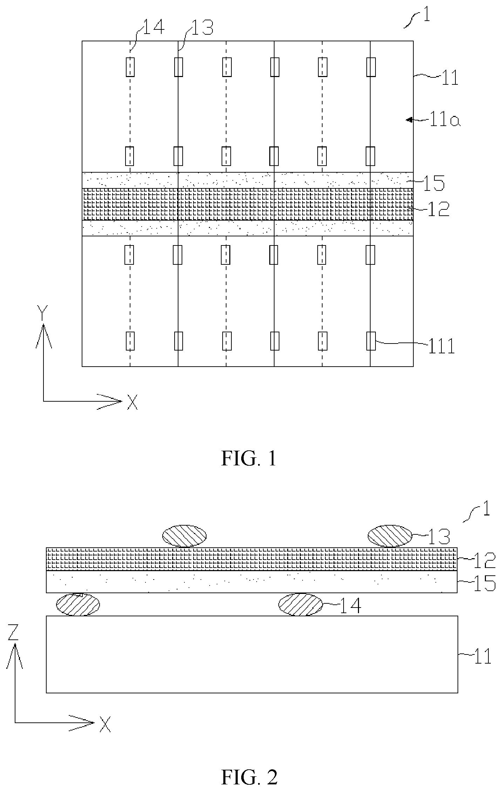

Referring to a schematic diagram of a back-contact solar cell module 1 as shown in FIG. 1, the back-contact solar cell module 1 includes a plurality of connected solar cell strings (not shown). Each solar cell string includes a plurality of solar cells 11, a busbar 12 arranged over the solar cells 11, a plurality of first-polarity solder strips 13, a plurality of second-polarity solder strips 14, and an insulating film 15.

This embodiment is described by taking one solar cell 11 and components connected to the solar cell 11 as an example. The solar cell 11 has a front surface and a back surface 11a arranged opposite to each other. A busbar 12, a plurality of first-polarity solder strips 13, a plurality of second-polarity solder strips 14, and an insulating film 15 are all arranged above the back surface 11a of the solar cell 11.

In one or more embodiments, the back surface 11a of the solar cell 11 is provided with a plurality of first-polarity gridlines (not shown) and second-polarity gridlines (not shown) that are alternately arranged. The first-polarity solder strips 13 and the second-polarity solder strips 14 are alternately arranged over the back surface 11a of the solar cell 11, and the first-polarity solder strips 13 are correspondingly soldered and connected to the first-polarity gridlines, so that the first-polarity solder strips 13 and the first-polarity gridlines are electrically connected. The second-polarity solder strips 14 are correspondingly soldered and connected to the second-polarity gridlines, so that the second-polarity solder strips 14 and the second-polarity gridlines are electrically connected. Therefore, the first-polarity solder strips 13 and the second-polarity solder strips 14 play a role of guiding currents.

The first-polarity gridlines and the second-polarity gridlines may be arranged over the back surface 11a of the solar cell 11 by screen printing.

With continued reference to FIG. 1, the first-polarity solder strips 13 are electrically connected to the busbar 12, so that the busbar 12 can collect currents on the first-polarity solder strips 13, thereby realizing current concentration and transport.

It should be noted that polarity of the first-polarity solder strip 13 is opposite to that of the second-polarity solder strip 14, and the first-polarity solder strip 13 may be a positive solder strip or a negative solder strip. For example, when the first-polarity solder strip 13 is a positive solder strip, the second-polarity solder strip 14 is a negative solder strip, the busbar 12 is connected to the positive solder strip, and the busbar 12 collects a current on the positive solder strip. When the first-polarity solder strip 13 is a negative solder strip, the second-polarity solder strip 14 is a positive solder strip, the busbar 12 is connected to the negative solder strip, and the busbar 12 collects a current on the negative solder strip.

FIG. 2 is a schematic cross-sectional view of a back-contact solar cell module 1 in some embodiments. Referring to FIG. 1 and FIG. 2 together, the insulating film 15 can isolate the busbar 12 from the solar cell 11, and along a thickness direction Z of the solar cell 11, the first-polarity solder strips 13 and the second-polarity solder strips 14 are respectively arranged on two sides of the insulating film 15. That is, the insulating film 15 can isolate the busbar 12 from contacting the solar cell 11, and the insulating film 15 can isolate the busbar 12 from contacting the second-polarity solder strips 14, to prevent a short circuit.

In the embodiments of the present disclosure, by arranging the busbar 12 over the back surface 11a of the solar cell 11, a space between the solar cells 11 is saved and a size of the back-contact solar cell module 1 is reduced, so that a structure of the back-contact solar cell module 1 is more compact, thereby helping improve area utilization of the back-contact solar cell module 1. Further, by arranging the busbar 12 over the back surface 11a of the solar cell 11, a length of connection between the first-polarity solder strip 13 and the busbar 12 is also shortened, thereby improving a current collection effect of the first-polarity solder strips 13. By arranging the busbar 12 over the back surface 11a of the solar cell 11 and by connecting the first-polarity solder strips 13 to the busbar 12, the busbar 12 can be fixed, and there is no need to fix the busbar 12 again.

In addition, in the embodiments of the present disclosure, by distributing the first-polarity solder strips 13 and the second-polarity solder strips 14 on two sides of the insulating film 15, the second-polarity solder strips 14 are arranged on the side of the insulating film 15 away from the busbar 12, so that the busbar 12 is insulated from the second-polarity solder strips 14, thereby preventing a short circuit caused by contact between the busbar 12 and the second-polarity solder strips 14.

Referring to FIG. 2, in one or more embodiments, the back-contact solar cell module 1 includes the solar cell 11, the insulating film 15, the busbar 12, the first-polarity solder strips 13, and the second-polarity solder strips 14. Along a thickness direction Z of the solar cell 11, the first-polarity solder strips 13 are arranged above the busbar 12, and the second-polarity solder strips 14 are arranged between the insulating film 15 and the solar cell 11.

In the embodiments of the present disclosure, the insulating film 15, the busbar 12, the first-polarity solder strips 13, and the second-polarity solder strips 14 are all arranged on the back surface 11a of the solar cell 11, the insulating film 15 is arranged between the busbar 12 and the solar cell 11, the second-polarity solder strips 14 are located between the insulating film 15 and the solar cell 11, the first-polarity solder strips 13 are located above the busbar 12, and other parts of the first-polarity solder strips 13 and the second-polarity solder strips 14 are respectively soldered to corresponding pads 111.

In the embodiments of the present disclosure, the first-polarity solder strips 13 above the busbar 12 can fix the busbar 12, and, the first-polarity solder strips 13 are not required to extend out of the solar cell 11 to be connected to the busbar 12, which helps improve current collection efficiency and stability of the back-contact solar cell module 1.

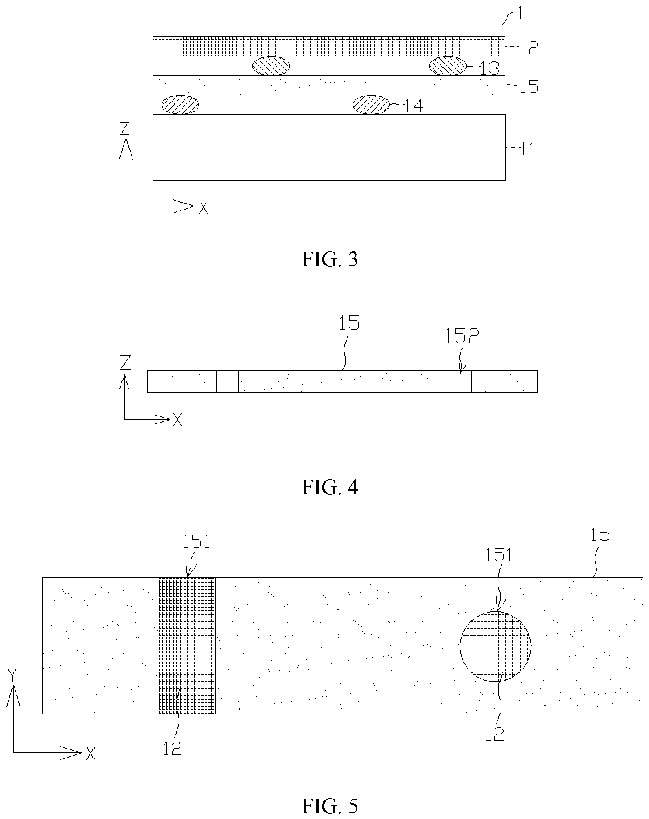

FIG. 3 is a schematic cross-sectional view of a back-contact solar cell in some other embodiments. The back-contact solar cell module 1 includes the solar cell 11, the insulating film 15, the busbar 12, the first-polarity solder strips 13, and the second-polarity solder strips 14. Along the thickness direction Z of the solar cell 11, the first-polarity solder strips 13 are arranged between the busbar 12 and the insulating film 15, and the second-polarity solder strips 14 are arranged between the insulating film 15 and the solar cell 11.

In the embodiments of the present disclosure, the insulating film 15, the busbar 12, the first-polarity solder strips 13, and the second-polarity solder strips 14 are all arranged on the back surface 11a of the solar cell 11, the insulating film 15 is arranged between the busbar 12 and the solar cell 11, the second-polarity solder strips 14 are located between the insulating film 15 and the solar cell 11, the first-polarity solder strips 13 are located between the busbar 12 and the insulating film 15, and other parts of the first-polarity solder strips 13 and the second-polarity solder strips 14 are respectively soldered to corresponding pads 111.

In the embodiments of the present disclosure, the first-polarity solder strips 13 located below the busbar 12 can fix the busbar 12, and the first-polarity solder strips 13 are not required to extend out of the solar cell 11 to be connected to the busbar 12, which helps improve current collection efficiency and stability of the back-contact solar cell module 1.

FIG. 4 is a schematic view of a cross section of an insulating film 15. The insulating film 15 is provided with second connecting holes 152. Referring to FIG. 2 and FIG. 4 together, the busbar 12 can be electrically connected to corresponding gridlines of the solar cell 11 through the second connecting holes 152.

In the embodiments of the present disclosure, the insulating film 15 is provided with the second connecting holse 152 passing therethrough along the thickness direction Z, so that when an upper end of the busbar 12 is electrically connected to the first-polarity solder strips 13, a lower end of the busbar 12 can be electrically connected to the first-polarity gridlines of the solar cell 11 through the second connecting hole 152, to make full use of each gridline of the solar cell 11, thereby better collecting the currents and improving a current convergence effect.

Alternatively, referring to FIG. 3 and FIG. 4 together, the insulating film 15 is provided with the second connecting holes 152, and the first-polarity solder strips 13 can be electrically connected to corresponding gridlines of the solar cell 11 through the second connecting holes 152.

In the embodiments of the present disclosure, the insulating film 15 is provided with the second connecting holes 152 passing therethrough along the thickness direction Z, so that the first-polarity solder strips 13 can be electrically connected to the first-polarity gridlines of the solar cell 11 through the second connecting holes 152, to cause the first-polarity solder strips 13 to be in full contact with the first-polarity gridlines. Even if the insulating film 15 is provided, it can also be ensured that the first-polarity solder strips 13 are connected to enough first-polarity gridlines, thereby making full use of each gridline of the solar cell 11 and effectively improving collection efficiency of the solar cell.

With continued reference to FIG. 1, the busbar 12 is arranged at a middle position of the back surface 11a of the solar cell 11, and a width of the insulating film 15 is greater than a width of the busbar 12, to prevent a short circuit of the solar cell 11 caused by contact between the busbar 12 and the solar cell 11.

In addition, the back surface 11a of the solar cell 11 is provided with a plurality of pads 111 configured to be connected to the solder strips. Along an extension direction Y of the first-polarity solder strips 13, the insulating film 15 is located between two adjacent pads 111, to prevent blocking the pads 111 by the insulating film 15.

In one or more embodiments, a thickness of the busbar 12 ranges from 0.1 mm to 0.2 mm.

For example, the thickness of the busbar 12 may be 0.11 mm, 0.12 mm, 0.13 mm, 0.14 mm, 0.15 mm, 0.16 mm, 0.17 mm, 0.18 mm, 0.19 mm, 0.2 mm, or the like.

In the embodiments of the present disclosure, the thickness of the busbar 12 should not be excessively large or excessively small. If the thickness of the busbar 12 is excessively large (e.g., greater than 0.2 mm), a height difference of the module may be increased, and great stress is generated during lamination of the module, easily causing hidden cracks. If the thickness of the busbar 12 is excessively small (e.g., less than 0.1 mm), a current collection rate is affected.

It should be noted that the thickness range of the busbar 12 may alternatively be further expanded or reduced according to actual requirements, which may be set according to the actual situation, which is not limited by the embodiments of the present disclosure.

In one or more embodiments, a width of the busbar 12 ranges from 6 mm to 14 mm.

For example, the width of the busbar 12 may be 6 mm, 7 mm, 8 mm, 9 mm, 10 mm, 11 mm, 12 mm, 13 mm, 14 mm, or the like.

In the embodiments of the present disclosure, the width of the busbar 12 should not be excessively large or excessively small. If the width of the busbar 12 is excessively large (e.g., greater than 14 mm), the busbar 12 may extend out of the insulating film 15, and there is a risk that the contact between the busbar 12 and a heteropolar solder strip may lead to a short circuit of the solar cell 11. If the width of the busbar 12 is excessively small (e.g., less than 6 mm), the current collection rate is affected.

It should be noted that the width range of the busbar 12 may alternatively be further expanded or reduced according to actual requirements, which may be set according to to actual situation and is not limited by the embodiments of the present disclosure.

In one or more embodiments, a thickness of the insulating film 15 ranges from 0.03 mm to 0.3 mm.

For example, the thickness of the insulating film 15 may be 0.03 mm, 0.06 mm, 0.09 mm, 0.12 mm, 0.15 mm, 0.18 mm, 0.21 mm, 0.24 mm, 0.27 mm, 0.3 mm, or the like.

In the embodiments of the present disclosure, the thickness of the insulating film 15 should not be excessively large or excessively small. If the thickness of the insulating film 15 is excessively large (e.g., greater than 0.3 mm), a height difference of the module may be increased, and great stress is generated during lamination of the module, easily causing hidden cracks. If the thickness of the insulating film 15 is excessively small (e.g., less than 0.03 mm), it is inconvenient to operate during pasting, it is easy to deform during being pulled, and there may be a risk of damage due to long-term insulation.

It should be noted that the thickness range of the insulating film 15 may alternatively be further expanded or reduced according to actual requirements, which may be set according to the actual situation and is not limited by the embodiments of the present disclosure.

In one or more embodiments, a width of the insulating film 15 ranges from 6 mm to 16 mm.

For example, the width of the insulating film 15 may be 6 mm, 7 mm, 8 mm, 9 mm, 10 mm, 11 mm, 12 mm, 13 mm, 14 mm, 15 mm, 16 mm, or the like.

In the embodiments of the present disclosure, the width of the insulating film 15 should not be excessively large or excessively small. If the width of the insulating film 15 is excessively large (e.g., greater than 16 mm), the insulating film 15 may block the pads 111 arranged adjacent thereto, thereby affecting the connection between the solder strips and the pads 111. If the width of the insulating film 15 is excessively small (e.g., less than 6 mm), the busbar 12 may be exposed, and there is a risk that the contact between the busbar 12 and a heteropolar solder strip may lead to a short circuit.

It should be noted that the width range of the insulating film 15 may alternatively be further expanded or reduced according to actual requirements, which may be set according to the actual situation and is not limited by the embodiments of the present disclosure.

In one or more embodiments, a spacing between two adjacent pads 111 ranges from 8 mm to 20 mm.

For example, the spacing between two adjacent pads 111 may be 8 mm, 9 mm, 10 mm, 11 mm, 12 mm, 13 mm, 14 mm, 15 mm, 16 mm, 17 mm, 18 mm, 19 mm, 20 mm, or the like.

In the embodiments of the present disclosure, the spacing between two adjacent pads 111 should not be excessively large or excessively small. If the spacing is excessively large (e.g., greater than 20 mm), adjacent fixed points on the solder strips are far apart. As a result, the solder strips cannot form a reliable connection with the corresponding gridlines, thereby affecting the current collection efficiency. If the spacing is excessively small (e.g., less than 8 mm), the insulating film 15 covers the pads 111 adjacent thereto, affecting the connection between the pads 111 and the solder strips.

It should be noted that the spacing between two adjacent pads 111 refers to a spacing between two adjacent pads 111 on the first-polarity solder strip 13 or refers to a spacing between two adjacent pads 111 on the second-polarity solder strip 14, rather than a spacing between the pad 111 on the first-polarity solder strip 13 and the pad 111 on the second-polarity solder strip 14.

It should be further noted that the spacing between two adjacent pads 111 may alternatively be further enlarged or reduced according to actual requirements, which may be set according to the actual situation and is not limited by the embodiments of the present disclosure.

Referring to FIG. 2 and FIG. 3 together, in one or more embodiments, along the thickness direction Z of the solar cell 11, the insulating film 15 may be arranged between the busbar 12 and the solar cell 11, to isolate the busbar 12 from the solar cell 11.

Alternatively, in one or more embodiments, the insulating film 15 may wrap the busbar 12 to isolate the busbar 12 from the solar cell 11. Referring to FIG. 5, which is a schematic diagram of an insulating film 15 wrapping the busbar 12. The insulating film 15 is provided with first connecting holes 151, and the busbar 12 is electrically connected to the first-polarity solder strips 13 through the first connecting holes 151. In the embodiments of the present disclosure, the busbar 12 is provided with the first connecting holes 151, and a soldering part of the busbar 12 is exposed through the first connecting holes 151, so that the busbar 12 is electrically connected to the first-polarity solder strips 13.

The first connecting hole 151 may be in the shape of a circle, a strip, or the like. The first connecting hole 151 ensures that the busbar 12 and the first-polarity solder strip 13 have a sufficient contact area. The specific shape may be set according to the actual situation, which is not limited by the embodiments of the present disclosure.

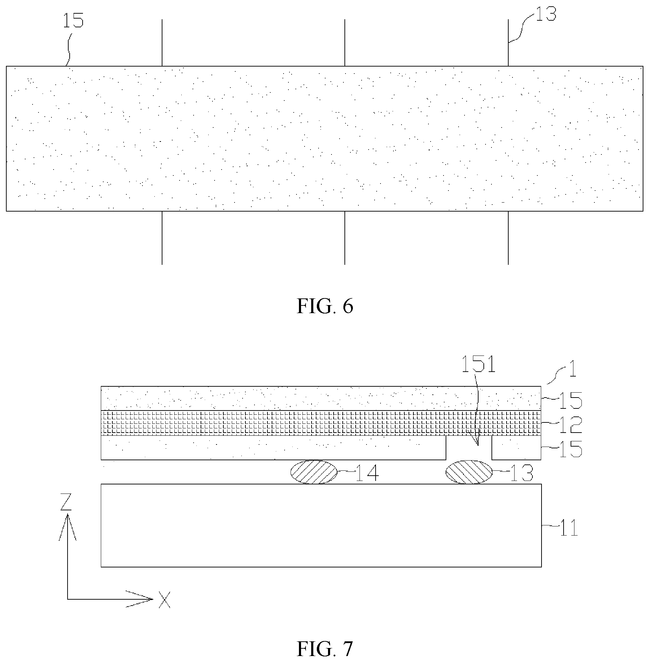

FIG. 6 is a schematic diagram of an insulating film 15 wrapping the busbar 12 and the first-polarity solder strips 13. The insulating film 15 may wrap the busbar 12 and some structures of the first-polarity solder strips 13 together, and other structures of the first-polarity solder strips 13 extend outward from the insulating film 15 and are used to be electrically connected to the first-polarity gridlines of the solar cell 11. In the embodiments of the present disclosure, by wrapping some structures of the first-polarity solder strips 13 and the busbar 12 together, there is no need to provide holes in the insulating film 15.

FIG. 7 is a schematic diagram of a back-contact solar cell module in some other embodiments. The back-contact solar cell module 1 includes the solar cell 11, the insulating film 15, the busbar 12, the first-polarity solder strips 13, and the second-polarity solder strips 14. Along the thickness direction Z of the solar cell 11, the first-polarity solder strips 13 and the second-polarity solder strips 14 are both arranged between the back surface 11a of the solar cell 11 and the insulating film 15, and the insulating film 15 wraps the busbar 12. A side of the insulating film 15 close to the first-polarity solder strip 13 is provided with the first connecting holes 151, and the busbar 12 is electrically connected to the first-polarity solder strips 13 through the first connecting holes 151.

In the embodiments of the present disclosure, the insulating film 15 is provided with the first connecting holes 151, so that the busbar 12 is electrically connected to the first-polarity solder strips 13 through the first connecting holes 151, thereby collecting the current on the first-polarity solder strips 13.

Alternatively, in one or more embodiments, the insulating film 15 in the embodiments shown in FIG. 7 may be arranged merely below the busbar 12.

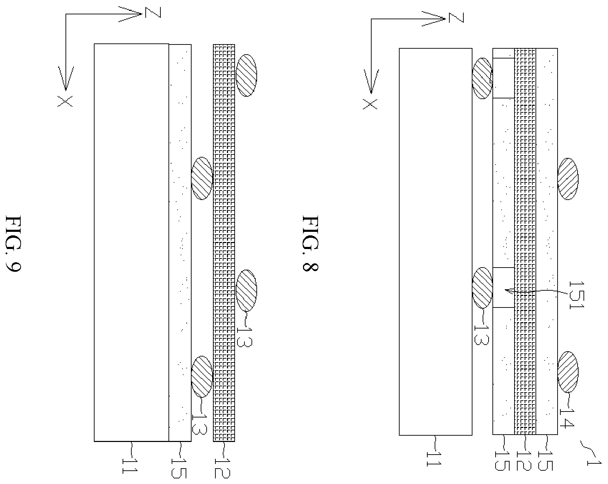

FIG. 8 is a schematic cross-sectional view of a back-contact solar cell module 1. The back-contact solar cell module includes the solar cell 11, the insulating film 15, the busbar 12, the first-polarity solder strips 13, and the second-polarity solder strips 14. Along the thickness direction Z of the solar cell 11, the insulating film 15 is distributed on two sides of the busbar 12, the first-polarity solder strips 13 are arranged between the insulating film 15 and the solar cell 11, the second-polarity solder strips 14 are arranged above the busbar 12, and they are isolated through the insulating film 15.

Along the thickness direction Z of the solar cell 11, the insulating film 15 between the busbar 12 and the first-polarity solder strips 13 is provided with the first connecting holes 151, and the busbar 12 is electrically connected to the first-polarity solder strips 13 through the first connecting holes 151.

In the embodiments of the present disclosure, the insulating film 15 between the busbar 12 and the first-polarity solder strip 13 is provided with the first connecting holes 151, so that the busbar 12 is electrically connected to the first-polarity solder strips 13 through the first connecting holes 151, thereby collecting the current on the first-polarity solder strips 13. In addition, the insulating film 15 is arranged above the busbar 12, which also isolates an electrical connection between the busbar 12 and the second-polarity solder strips 14, thereby preventing a short circuit.

FIG. 9 is a schematic cross-sectional view of a non-back-contact solar cell module 1. The non-back-contact solar cell module includes the solar cell 11, the insulating film 15, the busbar 12, and the first-polarity solder strips 13. The insulating film 15 isolates the busbar 12 from the solar cell 11, and adjacent first-polarity solder strips 13 are alternately distributed on two sides of the busbar 12.

In the embodiments of the present disclosure, the first-polarity solder strips 13 alternately arranged above and below the busbar 12 may fix the busbar 12.

Solder strips with different polarities in the non-back-contact solar cell module 1 are respectively arranged on the front surface and the back surface 11a of the solar cell 11. That is, in one or more embodiments, the first-polarity solder strips in the embodiments shown in FIG. 9 may all be arranged above the busbar 12 or below the busbar 12, which may be set according to the actual situation and is not limited by the embodiments of the present disclosure.

In one or more embodiments, the insulating film 15 may not be arranged between the busbar 12 and the solar cell 11 in the embodiments shown in FIG. 9, which may be set according to the actual situation and is not limited by the embodiments of the present disclosure.

Based on the back-contact solar cell module 1, embodiments of the present disclosure further provide a manufacturing method of a back-contact solar cell module, for manufacturing the back-contact solar cell module 1 described above.

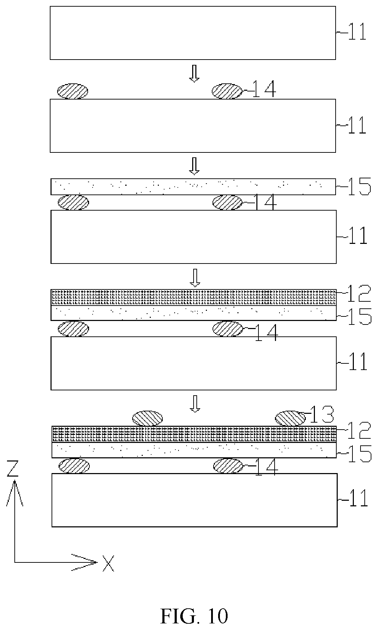

FIG. 10 is a flowchart of manufacturing of a back-contact solar cell module 1 in some embodiments. The manufacturing method includes:
S11: arranging second-polarity solder strips 14 on a back surface 11a of a solar cell 11, and soldering the second-polarity solder strips 14 to second-polarity gridlines of the solar cell 11;
S12: arranging an insulating film 15 on the back surface 11a of the solar cell 11;
S13: arranging a busbar 12 on the back surface 11a of the solar cell 11; and
S14: arranging first-polarity solder strips 13 on the back surface 11a of the solar cell 11, and soldering the first-polarity solder strip 13 to first-polarity gridlines of the solar cell 11.

Specific content and a technical effect of the manufacturing method in this embodiment may be obtained with reference to the foregoing, which is not described in detail in this embodiment.

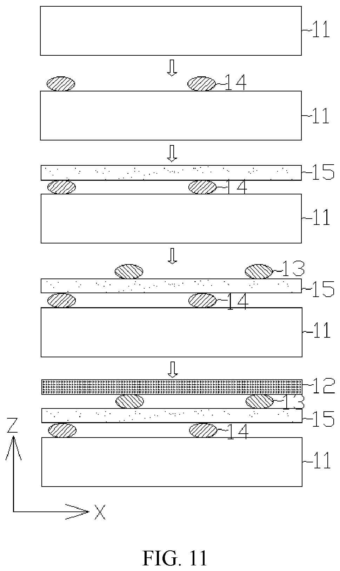

FIG. 11 is a flowchart of manufacturing of a back-contact solar cell module 1 in some other embodiments. The manufacturing method includes:
S21: arranging second-polarity solder strips 14 on a back surface 11a of a solar cell 11, and soldering the second-polarity solder strips 14 to second-polarity gridlines of the solar cell 11;
S22: arranging an insulating film 15 on the back surface 11a of the solar cell 11;
S23: arranging first-polarity solder strips 13 on the back surface 11a of the solar cell 11, and soldering the first-polarity solder strips 13 to first-polarity gridlines of the solar cell 11; and
S24: arranging a busbar 12 on the back surface 11a of the solar cell 11.

Specific content and a technical effect of the manufacturing method in this embodiment may be obtained with reference to the foregoing, which is not described in detail in this embodiment.

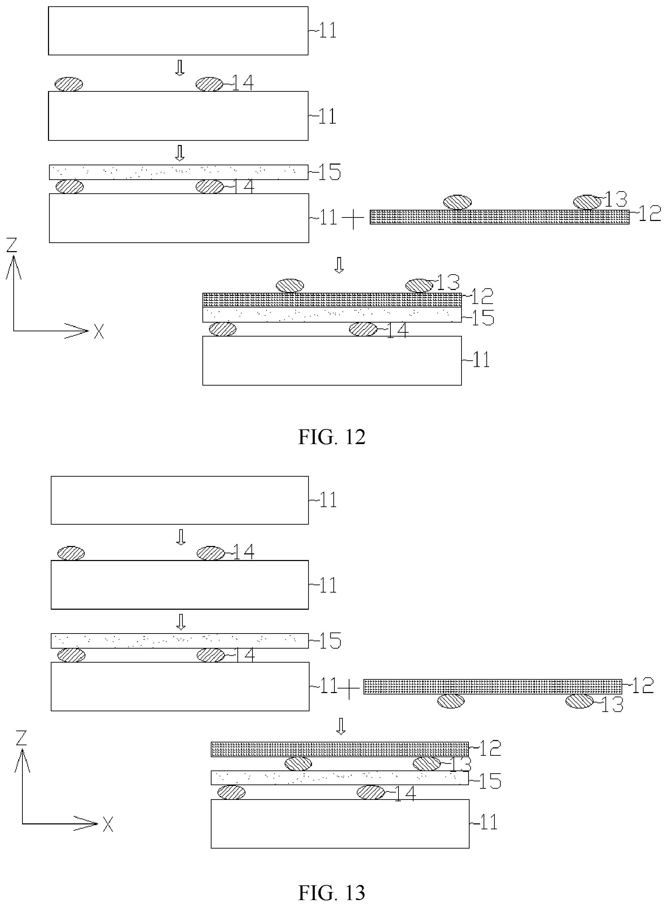

FIG. 12 is a flowchart of manufacturing of a back-contact solar cell module 1 in some other embodiments. The manufacturing method includes:
S31: arranging second-polarity solder strips 14 on a back surface 11a of a solar cell 11, and soldering the second-polarity solder strips 14 to second-polarity gridlines of the solar cell 11;
S32: arranging an insulating film 15 on the back surface 11a of the solar cell 11;
S33: first fixing first-polarity solder strips 13 above a busbar 12; and
S34: arranging the first-polarity solder strips 13 and the busbar 12 together on the back surface 11a of the solar cell 11, and soldering the first-polarity solder strips 13 to first-polarity gridlines of the solar cell 11.

Specific content and a technical effect of the manufacturing method in this embodiment may be obtained with reference to the foregoing, which is not described in detail in this embodiment.

FIG. 13 is a flowchart of manufacturing of a back-contact solar cell module 1 in some other embodiments. The manufacturing method includes:
S41: arranging second-polarity solder strips 14 on a back surface 11a of a solar cell 11, and soldering the second-polarity solder strips 14 to second-polarity gridlines of the solar cell 11;
S42: arranging an insulating film 15 on the back surface 11a of the solar cell 11;
S43: first fixing first-polarity solder strips 13 below a busbar 12; and
S44: arranging the first-polarity solder strips 13 and the busbar 12 together on the back surface 11a of the solar cell 11, and soldering the first-polarity solder strips 13 to first-polarity gridlines of the solar cell 11.

In one or more embodiments, the back-contact solar cell module includes a first cover plate, a first adhesive film, a solar cell string, a second adhesive film, and a second cover plate that are stacked. The solar cell string includes a plurality of solar cells electrically connected.

The first cover plate is located on a light-facing side of the solar cell string, the first cover plate is configured to transmit sunlight and improve waterproof and moisture-proof capabilities of the back-contact solar cell module, and the first cover plate seals the solar cell string together with the second cover plate. During lamination process of the back-contact solar cell module, the first adhesive film and the second adhesive film are configured to package the solar cell string to prevent an influence of an external environment on performance of the solar cell string, as well as can also bond the first cover plate, the solar cell string, and the second cover plate into an entirety.

The first cover plate may be made of coated glass or a fluorocarbon resin /polyethylene terephthalate (PET) composite transparent plate. The second cover plate may be made of glass, fluoropolymer, polyamide (PA), polyethylene (PE), PET, fluorocarbon resin (PEVE), polyvinylidene fluoride (PVDF), polyvinyl fluoride (PVF), or the like.

The first adhesive film and the second adhesive film may be made of one of an ethylene-vinyl acetate copolymer (EVA), a polyolefin elastomer (POE), a polyvinyl butyral (PVB), and the like, or may be made of an EPE adhesive film (an EVA-POE-EVA co-extruded structure) or an EP adhesive film (an EVA-POE co-extruded structure).

Specific content and a technical effect of the manufacturing method in this embodiment may be obtained with reference to the foregoing, which is not described in detail in this embodiment.

The above description are merely preferred embodiments of the present disclosure and are not intended to limit the present disclosure. For those skilled in the art, the present disclosure may have various modifications and changes. The protection scope of the present disclosure shall be defined by the appended claims.

## Claims

1. A back-contact solar cell module, comprising:
a solar cell (11);
a busbar (12) arranged on a back surface (11a) of the solar cell (11);
a plurality of first-polarity solder strips (13) and a plurality of second-polarity solder strips (14), wherein the first-polarity solder strips (13) and the second-polarity solder strips (14) are alternately arranged on the back surface (11a) of the solar cell (11), and the first-polarity solder strips (13) are electrically connected to the busbar (12); and
an insulating film (15) capable of insulating the busbar (12) from the solar cell (11), wherein along a thickness direction (Z) of the solar cell (11), the first-polarity solder strips (13) and the second-polarity solder strips (14) are respectively arranged on two sides of the insulating film (15).

2. The back-contact solar cell module according to claim 1, wherein along the thickness direction (Z) of the solar cell (11), the first-polarity solder strips (13) are arranged above the busbar (12), and the second-polarity solder strips (14) are arranged between the insulating film (15) and the solar cell (11).

3. The back-contact solar cell module according to claim 1, wherein along the thickness direction (Z) of the solar cell (11), the first-polarity solder strips (13) are arranged between the busbar (12) and the insulating film (15), and the second-polarity solder strips (14) are arranged between the insulating film (15) and the solar cell (11).

4. The back-contact solar cell module according to any one of claims 1 to 3, wherein along the thickness direction (Z) of the solar cell (11), the insulating film (15) is arranged between the busbar (12) and the solar cell (11).

5. The back-contact solar cell module according to any one of claims 1 to 4, wherein the insulating film (15) is provided with second connecting holes (152), and the busbar (12) is capable of being electrically connected to corresponding gridlines of the solar cell (11) through the second connecting holes (152); or
wherein the insulating film (15) is provided with second connecting holes (152), and the first-polarity solder strips (13) are capable of being electrically connected to corresponding gridlines of the solar cell (11) through the second connecting holes (152).

6. The back-contact solar cell module according to any one of claims 1 to 5, wherein the busbar (12) is arranged at a middle position of the back surface (11a) of the solar cell (11);
a width of the insulating film (15) is greater than a width of the busbar (12); and
a thickness of the busbar (12) ranges from 0.1 mm to 0.2 mm.

7. The back-contact solar cell module according to any one of claims 1 to 6, wherein the back surface (11a) of the solar cell (11) is provided with a plurality of pads (111);
along an extension direction (Y) of the first-polarity solder strips (13), the insulating film (15) is located between two adjacent pads (111); and
a spacing between the two adjacent pads ranges from 8 mm to 20 mm.

8. The back-contact solar cell module according to claim 1, wherein the busbar (12) is wrapped by the insulating film (15), first connecting holes (151) are provided at a side of the insulating film (15) close to the first-polarity solder strips (13), and the busbar (12) is electrically connected to the first-polarity solder strips (13) through the first connecting holes (151).

9. The back-contact solar cell module according to claim 8, wherein the first-polarity solder strips (13) are arranged between the insulating film (15) and the solar cell (11), the second-polarity solder strips (14) are arranged above the busbar (12), and the second-polarity solder strips (14) and busbar (12) are isolated through the insulating film (15).

10. The back-contact solar cell module according to claim 1, wherein the busbar (12) and some structures of the first-polarity solder strips (13) are wrapped by the insulating film (15), and other structures of the first-polarity solder strips (13) extend outward from the insulating film (15) and are configured to be electrically connected to corresponding gridlines of the solar cell (11).

11. The back-contact solar cell module according to any one of claims 1 to 10, wherein a width of the busbar (12) ranges from 6 mm to 14 mm.

12. The back-contact solar cell module according to any one of claims 1 to 11, wherein a thickness of the insulating film (15) ranges from 0.03 mm to 0.3 mm, and/or a width of the insulating film (15) ranges from 6 mm to 16 mm.

13. A manufacturing method of a back-contact solar cell module, for manufacturing the back-contact solar cell module (1) according to any one of claims 1 to 12, wherein the manufacturing method comprises:
arranging second-polarity solder strips (14) over a back surface (11a) of a solar cell (11), and soldering the second-polarity solder strips (14) to second-polarity gridlines of the solar cell (11);
arranging an insulating film (15) on the back surface (11a) of the solar cell (11); and
arranging a busbar (12) and first-polarity solder strips (13) over the back surface (11a) of the solar cell (11), and soldering the first-polarity solder strips (13) to first-polarity gridlines of the solar cell (11).

14. The manufacturing method of the back-contact solar cell module according to claim 13, wherein prior to the arranging a busbar (12) and first-polarity solder strips (13) over the back surface (11a) of the solar cell (11), the manufacturing method further comprises:
soldering and fixing the first-polarity solder strips (13) and the busbar (12).

15. The manufacturing method of the back-contact solar cell module according to claim 13 or 14, wherein the arranging a busbar (12) and first-polarity solder strips (13) on the back surface (11a) of the solar cell (11) comprises:
arranging the first-polarity solder strips (13) above the busbar (12); or
arranging the first-polarity solder strips (13) between the busbar (12) and the insulating film (15).

## Amended claims

### Amended claims in accordance with Rule 137(2) EPC.

1. A back-contact solar cell module, comprising:
a back-contact solar cell (11);
a busbar (12) arranged on a back surface (11a) of the back-contact solar cell (11);
a plurality of first-polarity solder strips (13) and a plurality of second-polarity solder strips (14), wherein the first-polarity solder strips (13) and the second-polarity solder strips (14) are alternately arranged on the back surface (11a) of the back-contact solar cell (11), and the first-polarity solder strips (13) are electrically connected to the busbar (12); and
an insulating film (15) capable of insulating the busbar (12) from the back-contact solar cell (11), wherein along a thickness direction (Z) of the back-contact solar cell (11), the first-polarity solder strips (13) and the second-polarity solder strips (14) are respectively arranged on two sides of the insulating film (15).

2. The back-contact solar cell module according to claim 1, wherein along the thickness direction (Z) of the back-contact solar cell (11), the first-polarity solder strips (13) are arranged on a side of the busbar (12) away from the back-contact solar cell (11), and the second-polarity solder strips (14) are arranged between the insulating film (15) and the back-contact solar cell (11).

3. The back-contact solar cell module according to claim 1, wherein along the thickness direction (Z) of the back-contact solar cell (11), the first-polarity solder strips (13) are arranged between the busbar (12) and the insulating film (15), and the second-polarity solder strips (14) are arranged between the insulating film (15) and the back-contact solar cell (11).

4. The back-contact solar cell module according to any one of claims 1 to 3, wherein along the thickness direction (Z) of the back-contact solar cell (11), the insulating film (15) is arranged between the busbar (12) and the back-contact solar cell (11).

5. The back-contact solar cell module according to any one of claims 1 to 4, wherein the insulating film (15) is provided with second connecting holes (152), and the busbar (12) is capable of being electrically connected to corresponding gridlines of the back-contact solar cell (11) through the second connecting holes (152); or
wherein the insulating film (15) is provided with second connecting holes (152), and the first-polarity solder strips (13) are capable of being electrically connected to corresponding gridlines of the back-contact solar cell (11) through the second connecting holes (152).

6. The back-contact solar cell module according to any one of claims 1 to 5, wherein the busbar (12) is arranged at a middle position of the back surface (11a) of the back-contact solar cell (11);
a width of the insulating film (15) is greater than a width of the busbar (12); and
a thickness of the busbar (12) ranges from 0.1 mm to 0.2 mm.

7. The back-contact solar cell module according to any one of claims 1 to 6, wherein the back surface (11a) of the back-contact solar cell (11) is provided with a plurality of pads (111);
along an extension direction (Y) of the first-polarity solder strips (13), the insulating film (15) is located between two adjacent pads (111); and
a spacing between the two adjacent pads ranges from 8 mm to 20 mm.

8. The back-contact solar cell module according to claim 1, wherein the busbar (12) is wrapped by the insulating film (15), first connecting holes (151) are provided at a side of the insulating film (15) close to the first-polarity solder strips (13), and the busbar (12) is electrically connected to the first-polarity solder strips (13) through the first connecting holes (151).

9. The back-contact solar cell module according to claim 8, wherein the first-polarity solder strips (13) are arranged between the insulating film (15) and the back-contact solar cell (11), the second-polarity solder strips (14) are arranged on a side of the busbar (12) away from the back-contact solar cell (11), and the second-polarity solder strips (14) and busbar (12) are isolated through the insulating film (15).

10. The back-contact solar cell module according to claim 1, wherein the busbar (12) and some structures of the first-polarity solder strips (13) are wrapped by the insulating film (15), and other structures of the first-polarity solder strips (13) extend outward from the insulating film (15) and are configured to be electrically connected to corresponding gridlines of the back-contact solar cell (11).

11. The back-contact solar cell module according to any one of claims 1 to 10, wherein a width of the busbar (12) ranges from 6 mm to 14 mm.

12. The back-contact solar cell module according to any one of claims 1 to 11, wherein a thickness of the insulating film (15) ranges from 0.03 mm to 0.3 mm, and/or a width of the insulating film (15) ranges from 6 mm to 16 mm.

13. A manufacturing method of a back-contact solar cell module, for manufacturing the back-contact solar cell module (1) according to any one of claims 1 to 12, wherein the manufacturing method comprises:
arranging second-polarity solder strips (14) over a back surface (11a) of a back-contact solar cell (11), and soldering the second-polarity solder strips (14) to second-polarity gridlines of the back-contact solar cell (11);
arranging an insulating film (15) on the back surface (11a) of the back-contact solar cell (11); and
arranging a busbar (12) and first-polarity solder strips (13) over the back surface (11a) of the back-contact solar cell (11), and soldering the first-polarity solder strips (13) to first-polarity gridlines of the back-contact solar cell (11).

14. The manufacturing method of the back-contact solar cell module according to claim 13, wherein prior to the arranging a busbar (12) and first-polarity solder strips (13) over the back surface (11a) of the back-contact solar cell (11), the manufacturing method further comprises:
soldering and fixing the first-polarity solder strips (13) and the busbar (12).

15. The manufacturing method of the back-contact solar cell module according to claim 13 or 14, wherein the arranging a busbar (12) and first-polarity solder strips (13) on the back surface (11a) of the back-contact solar cell (11) comprises:
arranging the first-polarity solder strips (13) on a side of the busbar (12) away from the back-contact solar cell (11); or
arranging the first-polarity solder strips (13) between the busbar (12) and the insulating film (15).
